# EUROPEAN PATENT SPECIFICATION

(11) **EP 2 103 993 B1**
(45) Date of publication and mention of the grant of the patent: **01.05.2013**
(21) Application number: 09004028.8
(22) Date of filing: 20.03.2009
(51) Int. Cl.: G03F 7/30

(54) **Automatic processing for making lithographic printing plate**
Automatische Verarbeitung zur Herstellung einer Lithografiedruckplatte
Traitement automatique pour fabriquer une plaque d'impression lithographique

(30) Priority: 21.03.2008 JP 2008074735
(43) Date of publication of application: 23.09.2009
(73) Proprietor: FUJIFILM Corporation, Minato-ku Tokyo (JP)
(72) Inventor: Ohishi, Chikashi, Haibara-gun Shizuoka (JP)
(74) Representative: HOFFMANN EITLE

(56) References cited:
- EP-A- 0 301 710
- EP-A- 0 415 392
- EP-A- 1 091 253
- EP-A- 1 437 626
- US-A- 4 091 404
- US-A- 4 740 075

## Description

### FIELD OF THE INVENTION

This invention relates to an automatic processing method for the production of a lithographic printing plate, particularly to an automatic processing method including dip development.

### BACKGROUND OF THE INVENTION

A lithographic printing plate generally has a lipophilic image area that receives ink in printing and a hydrophilic non-image area that receives a fountain solution. Lithography is a printing system making use of the mutually repellant properties of water and printing ink, in which the surface of a printing plate shows different ink receptivity between the lipophilic image area acting as an ink receptive region and the hydrophilic non-image area acting as a water-wettable region or an ink-repellent region so that ink may adhere only to the image area and be transferred to a material to be printed, such as paper.

A lithographic printing plate precursor (also called a presensitized plate, abbreviated as a "PS plate") having a water-wettable support and an ink-receptive photosensitive resin layer (image recording layer) formed on the support has been widely used as a precursor for making a lithographic printing plate. Lithographic printing platemaking is usually carried out by the steps of imagewise exposing a lithographic printing plate precursor through an original, such as a lith film, and removing non-image areas of the image recording layer by dissolving with an alkaline developer or an organic solvent while leaving image areas of the image recording layer, thereby exposing the water wettable support to form non-image areas.

In conventional lithographic platemaking, the step of imagewise exposure is followed by the step of removing unnecessary regions of the image recording layer by dissolving, e.g., with a developer. For environmental and safety considerations, the challenges, therefore, are to use a developer close to neutrality and to reduce waste fluid. Seeing that the issue of disposal of waste fluid from wet processings has recently been of great concern to all industries from the geoenvironmental point of view, the need for solutions to the above challenges have been increasing.

On the other hand, image information digitalization for electronically processing, storing and outputting image information on computers have been spread widely, and various new image output systems coping with such digitalization technologies have been put to practical use. Along with this technological advancement, the computer-to-plate (CTP) technology is attracting attention, in which digital image

information is directly written on a lithographic printing plate precursor by scanning with highly convergent radiation, such as a laser beam, with no use of a lith film. It has now been one of main technical issues to provide a lithographic printing plate precursor adaptive to the CTP technology.

As stated, the demands for reducing alkalinity of a developer and simplifying processing steps have ever been increasing not only for geoenvironmental considerations but also from the aspect of space and running cost saving. The development step, however, generally consists of three substeps: development with an alkaline developer at pH 10 or higher, washing in a washing bath to remove an alkali agent, and gumming with a gum solution mainly comprising a hydrophilic resin. Therefore, an automatic processing apparatus to carry out these substeps requires much space, and the development step produces waste fluids including the developer, the washing, and the gum solution. This leaves environment and running cost problems.

To address the problems, JP 2002-91016A proposes a developing method using an alkaline solution containing a nonionic surfactant and having a pH of 10 to 12.5. The proposal is predicated on use of a photosensitive composition containing an alkali soluble polymer, involving the objection that development is not achieved if the pH of the developer is lower than the range recited.

Japanese Patent 2938397 discloses a lithographic printing plate precursor having, on a water-wettable support, an image forming layer made of hydrophobic thermoplastic polymer particles dispersed in a hydrophilic binder. According to the teachings, the precursor is imagewise exposed to an infrared laser beam to cause the hydrophobic thermoplastic polymer particles to thermally coalesce to form an image, and the exposed precursor is fixed to the cylinder of a printing press and on-press developed with a fountain solution and/or ink. Although the precursor has good on-press developability, the resulting printing plate has insufficient press life on account of extremely low adhesion of the image layer to the support.

To provide a solution to the above problem, JP 2003-316021A proposes a process of making a lithographic printing plate, in which an image is recorded on a printing plate precursor having, on a support, a heat sensitive image recording layer containing fine polymer particles, and the exposed precursor is processed on an automatic processor equipped with an abrading member where the recording layer is abraded with the abrading member in the presence of a developer thereby to remove the image recording layer from the non-exposed area.

EP-A-1 437 626 discloses a developer replenishing method of an automatic developing apparatus for a photosensitive lithographic printing plate wherein an electric conductivity value of the developer is measured in a predetermined given cycle, a when the measured value of the developer is lower than the target value, the developer is replenished with a predetermined amount of a developer replenisher, and the time interval between the previous supply of the developer replenisher and the present supply of the developer replenisher is measured, based on the measured replenishment time interval and the replenishment time interval threshold value a target electric conductivity arithmetic expression is selected, and using this target expression and the measured replenishment time interval, the target electric conductivity value is updated.

### SUMMARY OF THE INVENTION

Reduction in alkalinity of a developer and simplification of processing impose a heavy load on the step of development processing. For instance, while it is easy to remove a photosensitive layer with an alkaline developer, using a low alkaline developer makes it difficult. A photosensitive layer that remains undissolved again adheres to the printing plate to become scum on the plate, which deteriorates appearance of the printing plate and eventually results in contamination of printed matter. In some cases, the residual photosensitive layer contaminates inside the processor, which can increase the time and labor needed for maintenance.

The tendencies to lower alkalinity and simplified processing have shifted the processing system from a dipping system to a spraying system in which a printing plate precursor is horizontally transported and treated with a spray of a developer. The problem with this horizontal transport system is that the developer is prone to splash, and the splashed developer easily dries to scum. The horizontal transport system essentially has the problem that the developer readily dries when a processing apparatus is out of operation and that a brushing member, a roller, and like members are liable to be contaminated with the dried developer to produce scum. Therefore, designing a horizontal transport system meets very high technical hurdle to overcome.

Furthermore, a developer is exhausted with the volume of processing and needs replacement as appropriate. Assuming that a user handling a large quantity of printing plate precursors and a user handling a small quantity of precursors use the same amount of the same developer, the degree of exhaustion of the developer at a certain time differs between the users. If a developer is to be replaced when the degree of exhaustion of the developer reaches 100% for each user, the replacement cannot be done all at once, and the working efficiency reduces considerably. If all the developers used by different users are replaced at the same time when the developer of a user handling the largest quantity of precursors is 100% exhausted, this means that the developer of a user handling a smaller quantity of precursors is replaced in spite that it still has developing capacity. This is nothing but waste. If, on the other hand, all the developers used by different users are replaced at the same time when the developer of a user handling the smallest quantity of precursors is 100% exhausted, this means that the developer of a user handling a larger quantity of precursors has already been exhausted by that time. If processing is continued with a developer having been 100% exhausted, the components originated in the photosensitive layer or protective layer that have been dissolved or dispersed in the developer can accumulate on the inner wall of the processing tank, which will make it laborious to clean the tank in replacing the developer.

As used herein, the term "100% exhausted" is intended to mean the state of a developer having reduced its processing capacity to such a degree that development of a half-exposed fringe area around a dot becomes noticeably slow, for example, such that a half tone dot area ratio of 50% that should have been achieved with a fresh developer increases to, e.g., 52%. When a half tone dot area ratio increases, e.g., by 2% on the printing plate, the reflective density on finished printed matter increases, which visually represents the influence on tone reproduction. Accordingly, the threshold of developability discussed here indicates a decrease that is, though very slight, obviously affects printing performance. The threshold value in terms of percentage of the increase in half dot area ratio varies from user to user and is therefore determined by individual users.

The present invention has been made in order to eliminate the disadvantages associated with the conventional automatic processing method and apparatus. Accordingly, an object of the invention is to provide a method of automatically developing a lithographic printing plate precursor to provide a high quality lithographic printing plate.

Another object of the invention is to provide a method of automatically developing a lithographic printing plate precursor, which method enables a user of any scale to replace a developer having 100% exhausted its processing capacity within a certain period of time.

The above objects of the invention are accomplished by the provision of an automatic processing method for obtaining a lithographic printing plate, comprising dipping an imagewise exposed lithographic printing plate precursor comprising a support and an image recording layer in a development tank filled with a developer to remove an unnecessary part of the image recording layer, which method further comprises:
- providing an external tank outside a processing line including the development tank;
- circulating the developer through the development tank and the external tank to maintain liquid level of the development tank constant; and
- when the developer in both the development tank and the external tank is 100% exhausted, replacing only the developer of the external tank, followed by continuing development processing.
wherein "100% exhausted" means a state of the developer, wherein the half-tone dot area ratio increases to 52% whilst a half tone dot area ratio of 50% is obtained with a fresh developer.

The invention provides a preferred embodiment of the processing method, in which, after the developer of the external tank is replaced at least once, the entire developer in both the development tank and the external tank is replaced, and the development processing is continued thereafter.

The invention also provides another preferred embodiment of the processing method, in which the developer contains 1% to 15% by mass of a surfactant as a main ingredient and has a pH of 2 to 10.

The invention also provides still another preferred embodiment of the processing method, in which the developer contains 1% to 15% by mass of a water soluble polymer.

According to the present invention, lithographic printing plates of constant quality are manufactured without involving the problems of contamination and scumming in an automatic processing apparatus.

Because the liquid level of the development tank is kept constant, the processing is performed constantly satisfactorily. Because the developer is used while being circulated, the amounts of a developer replenisher and a waste fluid are reduced, which is advantageous for running cost reduction and environmental protection.

Because part of the developer still having processing capacity is not disposed of, the processing capacity may be made full use of. This results in reduction of total quantity of waste fluid, which leads to processing cost reduction. This effect is especially appreciable in automatic processing requiring an increased amount of a developer.

The processing capacity of a developer (the area developable with unit amount of a developer) may be maintained by replacing only the developer in the external tank every time the developer in both the development tank and the external tank is 100% exhausted. Accordingly, the control on the processing capacity and timing of replacement (e.g., 1 week to 6 months) of the developer may be standardized among users of different scales. This brings about a reduction in waste of the developer and makes it possible to periodically replace the entire developer in both the development tank and the external tank of users of different scales all at once, resulting in improved working efficiency.

In order to adapt an automatic processing apparatus to the processing system of the invention, it is preferred that the developer be less likely to reduce its capacity by carbon dioxide in the air. A developer with a high pH largely changes pH with time by carbon dioxide, while a developer with a pH as low as 2 to 10 undergoes less change in pH with time. In other words, to use a developer with a low pH eliminates the need to take into account the factor of exhaustion with time, thus facilitating designing the processing system. To use a low pH developer offers another advantage of safety in handling.

Addition of 1% to 15% by mass of a surfactant compensates for the reduction in developing properties due to the low pH.

Because a water soluble polymer in the developer forms a non-image area protective film, using the developer containing the water soluble polymer establishes a simple, monobath processing system that does not need a washing part and a gumming part and achieves size reduction of equipment, reduction of waste fluids, and reduction in required maintenance (e.g., reduction in time for washing and replacement and reduction of mechanical failure).

Being of dip type, the development tank enables stable processing and may be designed to have an enclosed, air-tight structure so as to protect the developer from evaporation loss and deterioration with time.

### BRIEF DESCRIPTION OF THE DRAWINGS

Fig. 1 is a diagram of an automatic processing apparatus incorporating a first embodiment of the invention.
Fig. 2 is a diagram illustrating the relation between degree of exhaustion of a developer and processed area of a lithographic printing plate precursor.
Fig. 3 is a diagram of an automatic processing apparatus incorporating a second embodiment of the invention.
Fig. 4 is a diagram of an automatic processing apparatus incorporating a third embodiment of the invention.

### [Description of Numerals]

2, 2', 2": Automatic processing apparatus of the invention
4: Photosensitive lithographic print plate precursor (PS plate)
6: Development part
10: Drying part
12: Side wall
14: Inlet
16: Feed roller
18: Rubber blade
20: Development tank
22: Conveyor roller
24: Brush roller
26: Squeegee roller
27: Plate sensor
28: Back-up roller
36: Guide roller
38: Segmented roller
40: Outlet
46: Pathway
50: Controller
51: Control ROM and RAM
52: Time measurement section
55: Developer reservoir (external tank)
58: Developer
60: Lid
62: Rubber blade
71: Pump
73: Conductivity sensor
74: Developer supply pump
80: First circulation pipe
90: Second circulation pipe
98: Display device
99: Alarming device

### DETAILED DESCRIPTION OF THE INVENTION

The present invention will be described in detail based on its best modes with reference to the accompanying drawing.

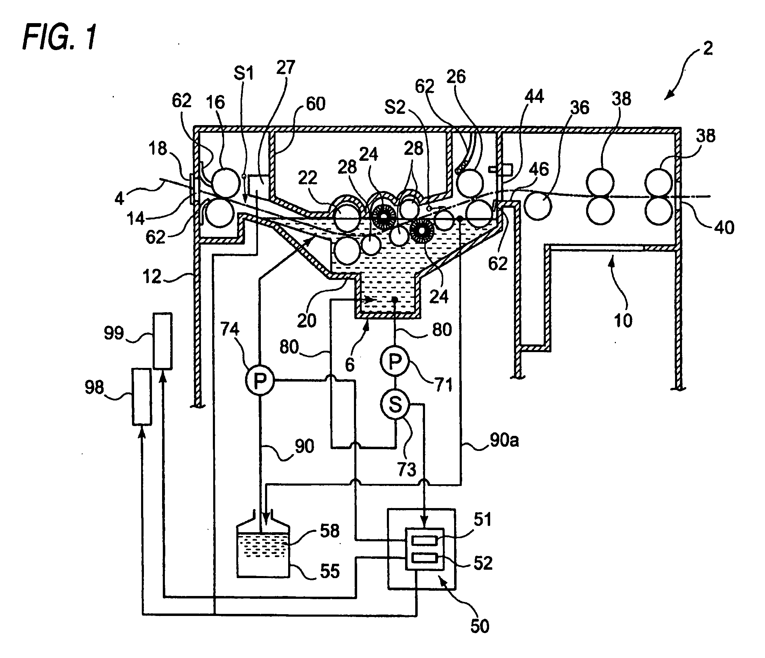

Fig. 1 is a diagram showing an automatic processing apparatus 2 incorporating a first embodiment of the invention. As illustrated, the automatic processing apparatus 2 includes a developing part 6 where a photosensitive lithographic printing plate precursor (hereinafter referred to as a PS plate) 4 is developed and gummed and a drying part 10 where the developed PS plate 4 is dried.

The automatic processing apparatus 2 has on its side wall 12 an inlet 14, through which a PS plate 4 is introduced and transported to the developing part 6 by a pair of feed rollers 16. The inlet 14 is fitted with rubber blades 18 so that the inlet 14 may be closed by the rubber blades 18 in the absence of a PS plate.

The developing part 6 has a development tank 20, in which conveyor rollers 22, brush rollers 24, and squeegee rollers 26 are arranged in this order in the downstream direction, with backup rollers 28 disposed at appropriate locations therebetween. The development processing of the PS plate 4 is carried out by transporting the PS plate 4 into the developer by the conveyor rollers 22 and brushing the PS plate 4 as dipped in the developer with the rotating brush roller 24 to remove the non-image area of the PS plate 4. The details of the developing processing will be described later.

The thus developed PS plate 4 is sent to the drying part 10 by the squeegee rollers (delivery rollers) 26.

The drying part 10 has a guide roller 36 and pairs of segmented rollers 38 in this order in the downstream direction. The drying part 10 also has a drying unit, such as a hot air feeder or a heat generator, while not shown. The drying part 10 has an outlet 40, from which the dried PS plate 4 is discharged. A shutter 44 is provided on a pathway 46 between the drying part 10 and the developing part 6 so that the pathway 46 is closed by the shutter 44 in the absence of a PS plate 4.

The development tank 20 is covered with a box-shaped lid 60 that is integral with the wall of the tank 20. The bottom of the lid 60 is contoured to the arcuate upper part of the upper conveyor roller 22, the arcuate upper part of the upper brush roller 24, and the arcuate upper part of the upper back-up roller 28 but is not in contact with these parts so as not to interfere with the rotation of the rollers.

The box-shaped lid 60 defines an air-tight space above the development tank 20 to minimize the amount of air present in the developing part 6. The lid 60 is also designed to minimize the contact area between the developer and air.

The automatic processing apparatus 2 has another pair of rubber blades 62 inside the inlet 14 in contact with the feed rollers 16 to prevent ambient air from entering so as to keep the inside of the developing part 6 substantially air tight.

The outlet of the developing part 6 is also fitted with a rubber blade 62 in contact with the upper delivery roller 26 to prevent entering air from the drying part 10 so as to keep the developing part 6 substantially air tight.

Accordingly, the developing part 6 is configured to be substantially air tight, allowing substantially no air to enter except for more or less air flowing in together with the PS plate 4 passing therethrough.

Numeral 98 indicates a display device visually signaling necessary information, and numeral 99 indicates an alarming device giving an acoustic signal.

The developing tank 20 is connected to a first circulation pipe 80 for circulating the developer. The first circulation pipe 80 is provided with a pump 71 for developer circulation, a conductivity sensor 73, and a filter (not shown) .

The pump 71 sucks the developer from the suction hole at the bottom of the development tank 20 and makes the sucked developer pass through the first circulation pipe 80 and return into the development tank 20. The filter filters the developer flowing in the first circulation pipe 80. The conductivity sensor 73 monitors the electroconductivity of the developer flowing in the pipe 80.

The development tank 20 has a second circulation pipe 90 connected thereto. The second circulation pipe 90 is fitted with a developer supply pump 74 and led to a developer reservoir (external tank) 55. The second circulation pipe 90 is configured to receive an overflow from the development tank 20 and return it to the developer reservoir 55.

In more detail, a pair of second circulation pipes 90 and 90a are provided near the development tank 20 to replenish the development tank 20 with a developer 58. The second circulation pipe 90 connects at the lower end thereof (the lower part of Fig. 1) to the external tank 55 and has the developer supply pump 74. The pump 74 meters the developer 58 from the external tank 55 and supplies it to the development tank 20. In short, the second circulation pipe 90, the pump 74, and the external tank 55 constitute a developer circulation system.

The developer supply pump 74 is controlled by a controller 50 (corresponding to first to fourth control means). The controller 50 has control ROM and RAM 51 (corresponding to first and second memory means) having stored therein developer replenishing conditions and the like and a time measurement section 52. The controller 50 controls the developer supply pump 74 based on the signals from a plate sensor 27 that detects the feed of a PS plate and measures the size of the plate and the time measurement section 52 so that the developer may be replenished (circulated) based on the replenishment conditions stored in the control ROM and RAM 51 and tailored to the actual operation conditions of the automatic processing apparatus 2. The controller 50 carries out replenishment with the developer 58 from the developer reservoir 55 in an amount satisfying the replenishment conditions, for example, for every processing cycle. Replenishment may be effected for every two or more processing cycles,

In the automatic processing apparatus 2, the image recording layer side of the PS plate 4 having passed between the feed rollers 16 is abraded with the brush roller (abrading member) 24 while being dipped in the developer 58 of the development tank 20, whereby the unexposed area (non-image area) of the image recording layer is removed. Since the abrasion is conducted in the developer 58 filling the developing tank 20, there hardly occurs a splash of the developer that would otherwise contaminate the inside of the processing apparatus and cause scumming. When a rotating brush roller is used as an abrading member, and the plate is brushed as dipped in the developer 58, it is preferred that the brush roller be immersed in the developer 58 to at least one-third its diameter, more preferably to at least half its diameter, in order to prevent a splash.

In order for the development tank 20 to have the above described configuration, the PS plate 4 having entered through the inlet 14 is conveyed obliquely downward and then dipped in the developer 58 and conveyed therein.

Abrasion with an abrading member is more effective when performed after an elapse of a certain time from entering the developer. According to the development system of the present embodiment, the developer 58 is allowed to penetrate the photosensitive layer of the PS plate to make it easier to remove the non-image area of the photosensitive layer. Dipping the PS plate in the developer 58 before the abrasion operation is therefore makes removal of the photosensitive layer more effective. According to experiments, the dipping time for achieving effective abrasion is preferably at least 2 seconds, more preferably 5 seconds or longer, even more preferably 10 seconds or longer, from the time when the area to be abraded is dipped in a developer or wetted with a spray of a developer. Seeing that development processing is usually completes in 60 seconds, the time elapsed before abrasion operation is of necessity shorter than 50 seconds.

The photosensitive layer of the PS plate may be wetted with the developer 58 using a spray tube S1 before it is dipped in the developer 58. The developer to be sprayed may be supplied from the external tank 55 or a separate tank containing a fresh developer. In this case, the photosensitive layer experiences an increased time from being wetted until it is abraded in the developer 58, resulting in more effective development. Furthermore, previously wetting with the developer 58 permits reduction in time from dipping to abrasion. In order to accelerate penetration of the developer 58, the PS plate 4 may be vibrated with the developer applied thereon.

Taking the time for the PS plate 4 from entering and emerging from the developer 58 as t seconds, it is preferably at last t/2 seconds after the entering the developer 58 that the PS plate is abraded with the brush roller 24. In other words, the development operation (abrasion) is desirably carried out in the middle or downstream of the middle of the development tank 20. The abrasion operation could be conducted in the upstream half of the development tank 20 if the dipping time is extended by lengthening the developing tank 20 or lowering the moving speed of the PS plate. In the system of the present embodiment, however, the abrasion operation with the brush roller 24 is ought to be effected in the middle or downstream half of the development tank 20.

After the PS plate 4 is developed with the brush roller 24, it emerges from the developer 58. In some cases, while depending on the situation of use, there is an increasing likelihood that scum adheres to the plate with the increasing degree of exhaustion of the developer 58. Even in such cases, the less exhausted developer 58 from the developer reservoir 55 may be sprayed through a spray tube S2 directly to the developed PS plate to remove foreign matter, such as scum, from the PS plate.

The spraying to remove scum produces an increasing effect with the degree of exhaustion of the developer 58 in the development tank 20 as previously stated. The spray tube S2 may be provided with a particularly fine filter as appropriate.

In the case of using the spray tube S2 to remove scum, a scum-free PS plate 4 is obtained within the developing part 6 so that a processing bath otherwise required between the development tank and the drying part may be dispensed with.

The PS plate that has been developed and desensitized in the monobath is then forwarded to the drying part 10 where it is dried. The present embodiment in which the development processing completes with a monobath solution enables reduction of equipment cost and space saving. Since the developer 58 is circulated using the external tank 55, the liquid level of the development tank is always kept constant, which secures stability of the development processing.

A conventional automatic processing apparatus is configured to involve disposal of part of a developer still having processing capacity. In the present invention, in contrast, the processing capacity of a developer is made full use of with no waste by circulating the developer, and the life of the developer is thus controllable. The liquid level of the development tank 20 is easily controlled by adjusting the overflow level. Incorporating a water soluble polymer in the developer achieves great effects through slight modification to the configuration of the existing automatic processing apparatus using the existing parts.

In the present invention, the external tank 55 contains a prescribed amount of a developer. When the entire developer 58 in both the development tank 20 and the external tank 55 is 100% exhausted, only the developer in the external tank 55 is replaced, and the development processing is continued. The replacement may be such that the external tank 55 as containing the exhausted developer is replaced with another external tank 55 containing a fresh developer.

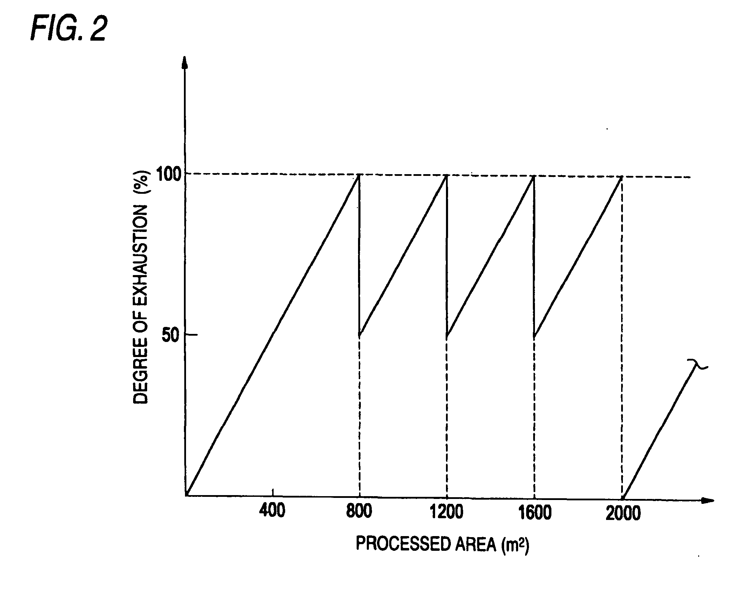

In the present invention, after the developer of the external tank 55 is replaced at least once, the entire developer of the development tank 20 and the external tank 55 is replaced, and the development processing is continued. Fig. 2 is a diagram illustrating the relation between degree of exhaustion and processed area. The abscissa represents the total area (m²) of PS plates having development-processed, and the ordinate indicates the degree of exhaustion of the entire developer of the development tank 20 and the external tank 55. A case is taken, for instance, in which 100 liters of a developer is capable of developing a total of 2000 m² of PS plates, and each of the developing tank 20 and the external tank 55 initially contains 20 liters of the developer. When the processed area reaches 800 m², the entire developer in both the development tank 20 and the external tank 55 becomes 100% exhausted. So, only the developer in the external tank 55 is replaced. As a result, the degree of exhaustion of the entire developer in both the development tank 20 and the external tank 55 reduces to about 50%. After the degree of exhaustion of the entire developer of the development tank 20 and the external tank 55 is reduced to 50%, the development processing is resumed. Thereafter, when the processed area after the resumption of operation reaches 400 m², the entire developer of the development tank 20 and the external tank becomes 100% exhausted again. Fig. 2 shows that the replacement of only the developer of the external tank 55 is repeated until the total processed area reaches 2000 m². When the total processed area reaches 2000 m², the entire developer in the development tank 20 and the external tank 55 is 100% exhausted, at which time the entire developer in the development tank 20 and the external tank 55 is replaced with an unused developer.

A case is taken in which the entire developer of the development tank 20 and the external tank 55 is regularly replaced once a month all at once irrespective of the processing scale of users, the developer used by a big user who processes a total of 2000 m² of PS plates per month experiences replacement of the developer of the external tank 55 three times between the periodic replacements as is indicated in Fig. 2, while a small user who processes a total of 1200 m² of PS plates per month conducts replacement of the developer of the external tank 55 only once between the periodic replacements. Both the developer having been used by the big user and the developer having been used by the small user reaches a 100% exhausted state at the time of the periodic replacement. That is, effective utilization of the developer is thus achieved.

As described, the present invention makes it feasible to standardize the control of processing capacity and timing of replacement of the developer among users of different scales. This reduces waste of the developer and permits periodical replacement of the entire developer in both the development tank and the external tank of users of different scales all at once, bringing about improved working efficiency.

Development systems commonly adapted to automatic processing include a system in which a developer is pumped up from a development tank and applied onto a PS plate through a spray nozzle (see JP 2003-316021A), a dip system in which a PS plate is conveyed by, e.g., guide rollers as dipped in a developer, and a no-return system in which a requisite amount of a substantially unused developer is supplied for every PS plate to be processed. The dip system is superior to any of others from the point of view of preventing a liquid splash. The present invention is applicable as well to a system having an exposure unit integrally combined with an automatic processing apparatus.

In the exposure unit, a PS plate 4 is exposed through a transparent original having a line image, a dot image, etc. or imagewise exposed by, for example, laser scanning based on digital data. Light sources suited for exposure include a carbon arc lamp, a mercury lamp, a xenon lamp, a metal halide lamp, a flash lamp, ultraviolet light, infrared light, and a laser beam. Laser beam radiation is preferred. For example, solid state lasers and semiconductor lasers emitting infrared rays of 760 to 1200 nm, UV semiconductor lasers emitting light of 250 to 420 nm, and argon ion lasers and FD-YAG lasers emitting visible light may be used. In view of ease and simplicity of platemaking, lasers emitting infrared light or ultraviolet light that permits working under a white lamp or a yellow lamp are particularly preferred.

Any abrading member may be used in the invention as long as it is capable of abrading the image recording layer of a PS plate. It is preferred to use a member that rotates about a rotating shaft to abrade the mage recording layer, including known channel, twisted, planted, and woven brushes and a molleton roller.

The channel brush that can be used is of the type having a roller body and a long channel brush element (strip brush element) helically wound around the roller body as disclose, e.g., in JP-U 62-167253A, JP-U 4-63447A, JP-U 4-64128, and JP 6-186751A.

The twisted brush that can be used is of the type having a helically grooved shaft and a twisted brush element fitted in the groove as disclosed, e.g., in JP 3-87832A.

The planted brush that can be used is of the type made by implanting bristles in small holes of a roller shaft.

The woven brush that can be used is of the type made by winding a woven strip having interwoven bristles around a roller shaft as disclosed, e.g., in JP 2001-5193A and JP 2001-66788.

The molleton roller that can be used is of the type having a roller body covered with a knitted fabric cylinder as a sliding contact member, with both ends of the cylindrical cover clamped, as disclosed, e.g., in JP 10-198044A.

In using a rotating member as an abrading member, the higher the rotational speed of the abrading member, the higher the performance of removing the non-image area of the image recording layer of the PS plate 4. Taking into consideration the durability and production cost of the automatic processing apparatus, possible splash of the developer 58, and possible damage to the exposed area of the PS plate 4, nevertheless, the rotational speed is preferably 30 to 1000 rpm, more preferably 50 to 500 rpm.

In using a brush as an abrading member, one or more than one brushes may be used. Where two or more brushes are used, at least one of them may rotate in the direction opposite to the moving direction of the PS plate 4. A rotating abrading member may vibrate transversely while rotating to improve the efficiency of removing the non-image area of the PS plate 4, thereby to provide higher quality printing plate.

Examples of materials known for bristles of the abrading member (brush) include natural fibers, such as horse hair and hog bristle, artificial fibers, and metal fibers. Artificial fibers are preferred for chemical resistance. Examples of artificial fiber materials include polyamides, such as nylon 6, nylon 6, 6, nylon 6,10, nylon 6,12, and nylon 12; polyesters, such as polyethylene terephthalate (PET) and polybutylene terephthalate (PBT), polyacrylic materials, such as polyacrylonitrile and polyalkyl (meth) acrylates; polyolefins, such as polyethylene, polypropylene, polystyrene, polyvinyl chloride, and polyvinylidene chloride; celluloses, such as acetyl cellulose; polyurethanes, such as polyurethane; polyphenylene sulfite; and fluoropolymers, such as ethylene-tetrafluoroethylene copolymers and polyvinylidene fluoride. In terms of elasticity, stiffness, wearability, heat resistance, chemical resistance, water and moisture absorbing properties, and so forth, preferred of them are nylon 6, nylon 6,6, nylon 6, 10, nylon 6,12, nylon 12, polypropylene, PBT, and PET; particularly nylon 6,6, nylon 6,10, nylon 6,12, nylon 12, PBT, and polypropylene. Of the polyesters PBT is preferred. Of the polyolefins polypropylene is preferred.

The thickness of the bristles is preferably, but not limited to, 0.01 to 1.0 mm, more preferably 0.1 to 0.5 mm. Bristles thinner than 0.01 mm have poor abrading properties. Bristles thicker than 1.0 mm are liable to scratch the plate surface. The length of the bristles is preferably, but not limited to, 3 to 50 mm. Bristles shorter than 3 mm may have non-uniform contact with the PS plate 4, tending to scratch the plate surface. Increasing the bristle length over 50 mm brings about no further improvement in performance but waste. In the case of a molleton roller, i.e., a roller covered with a cylindrical sliding contact member made of knitted fabric, there is, of necessity, no preference with respect to bristle thickness and length.

The first embodiment produces the following effects and advantages. Since the PS plate 4 is developed and desensitized at the same time in the development tank and then dried in the drying part 10, the cost and space for the equipment to complete the processing are saved. Since development and abrasion are performed below the liquid level of the development tank, a splash of the developer is avoided as compared with an automatic processing apparatus of horizontal transport system using a similarly low-alkaline developer. As a result, the problem of a splash drying to scum is eliminated. Since the developer 58 circulates, its liquid level is kept constant to achieve stable development processing.

The present invention is not limited to monobath processing. The development processing may be followed by washing, followed by drying, and followed by desensitization. In this case, too, the air tight structure of the development tank and the developer circulatory structure retard the developer exhaustion due to contact with air and provide a solution to the problem of wasteful spending of the developer (a conventional processing apparatus with no such circulatory system involves waste of material because a developer is withdrawn despite its not having 100% exhausted).

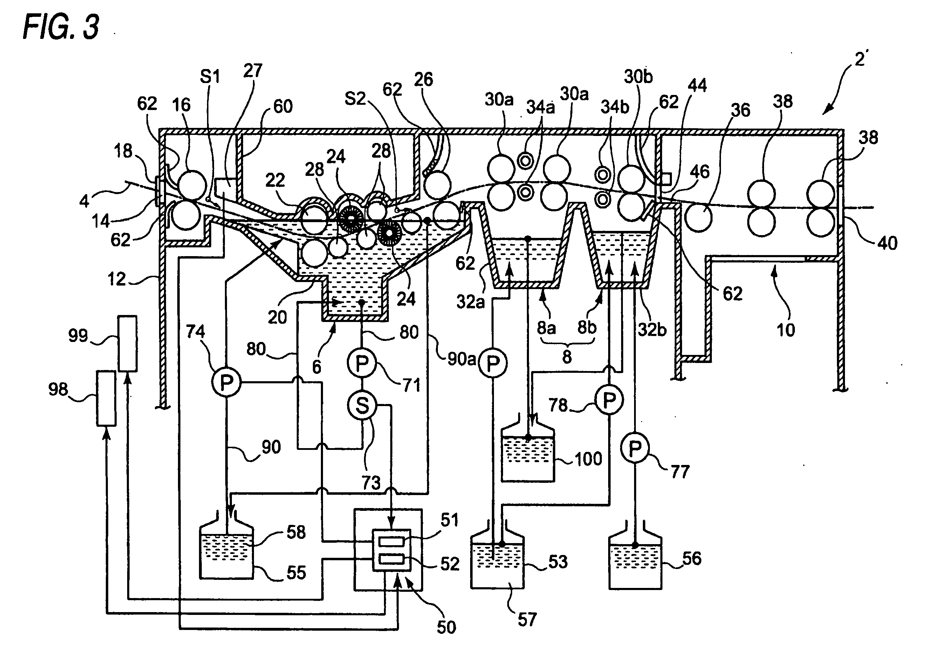

A second embodiment of the present invention will then be described with reference to Fig. 3. Fig. 3 illustrates a diagram of an automatic processing apparatus 2' according to the second embodiment. In Fig. 3, members identified with the same numerals as in Fig. 1 may be identical and will not be redundantly described.

The automatic processing apparatus 2' includes a developing part 6, a finisher part 8, and a drying part 10. The developing part 6 of the apparatus 2' is basically equal to that of the apparatus 2 shown in Fig. 1 with a slight difference of the location of the shutter 44. The shutter 44, which is provided in the pathway between the drying part 10 and the developing part 6 in the first embodiment, is shifted to the pathway between the finisher part 8 and the drying part 10. A great difference between the first and second embodiments resides in the provision of the finisher part 8 downstream of the developing part 6 and upstream of the drying part 10. In the finisher part 8, the developer adhering to the developed PS plate 4 is washed away, and a gum solution is applied to the washed PS plate. While development and gumming is carried out simultaneously in the first embodiment, the two processing steps are separately conducted in the second embodiment.

The finisher part 8 consists of a first finisher subpart 8a and a second finisher subpart 8b. The first and second finisher subparts 8a and 8b have first and second finisher tanks 32a and 32b, respectively, each containing a gum solution, pairs of conveyor rollers 30a and 30b, respectively, for transporting the PS plate 4, and spray members 34a and 34b, respectively, for spraying the gum solution of the respective finisher tanks 32a and 32b. The development processed PS plate 4 is coated with the gum solution sprayed from the spray members 34a and 34b while being transported by the conveyor rollers 30a and 30b. The gum solution in the second finisher tank 32b of the second, downstream finisher subpart 8b is made to overflow and supplied to the first finisher tank 32a of the first, upstream finisher subpart 8a. Otherwise, the first finisher tank 32a may be replenished with a fresh gum solution, e.g., through a pump.

The shutter 44 is provided in the pathway between the finisher part 8 and the drying part 10 so that the pathway 46 may be closed by the shutter 44 in the absence of the PS plate 4.

The second finisher tank 32b is replenished with a gum solution from a gum solution reservoir 56 through a pump 77 and also replenished with a diluent 57 from a diluent reservoir 53 through a pump 78. The replenishment rate ratio of gum solution to diluent is, for example, 1:1. An overflow from the first finisher tank 32a accompanying the replenishment is collected in a waste fluid tank 100 similarly to the exhausted developer.

Rubber blades 62 are disposed at appropriate positions in the automatic processing apparatus 2' so that the developing part 6 to the finisher part 8 may be configured to have substantial air-tightness and prevent ambient air from entering. Air flow between the developing part 6 and the first finisher subpart 8a is also substantially shuttered by rubber blades 62. Accordingly, the developing part 6 is configured to be substantially air tight, allowing substantially no air to enter except for more or less air flowing in together with the PS plate 4 passing therethrough.

Similarly to the first embodiment, the apparatus 2' has an external tank 55, whereby the developer 58 circulates so as to keep the liquid level of the development tank 20 constant. When the entire developer in the development tank 20 and the external tank 55 is 100% exhausted, only the developer of the external tank 55 is replaced, and the development processing is continued. After the developer of the external tank 55 is replaced at least once, the entire developer of both the development tank 20 and the external tank 55 is replaced, and the development processing is continued.

By so configuring, the present embodiment makes it feasible to standardize the control of processing capacity and timing of replacement of the developer among users of different scales. This reduces waste of the developer and permits periodical replacement of the entire developer in both the development tank and the external tank of users of different scales all at once, bringing about improved working efficiency.

According to the second embodiment, in which development processing and desensitization processing are separately carried out, replacement of exhausted processing solutions may be conducted for individual processing parts. As a result, each processing solution is effectively used independently.

Since the developer 58 circulates, usability of the developer improves, and the developer liquid level is always kept constant to achieve stable development processing. The air tight structure of the development tank minimizes evaporation loss and retards the developer exhaustion due to contact with air. This permits use of a highly alkaline developer (pH 13) (for thermal positive plates) and a thermal CTP plate.

Since development and abrasion are performed below the liquid level of the development tank, a splash of the developer is avoided similarly to the first embodiment, as compared with an automatic processing apparatus of horizontal transport system using a similarly low-alkaline developer. Consequently, the problem with a splash that it dries to scum is eliminated.

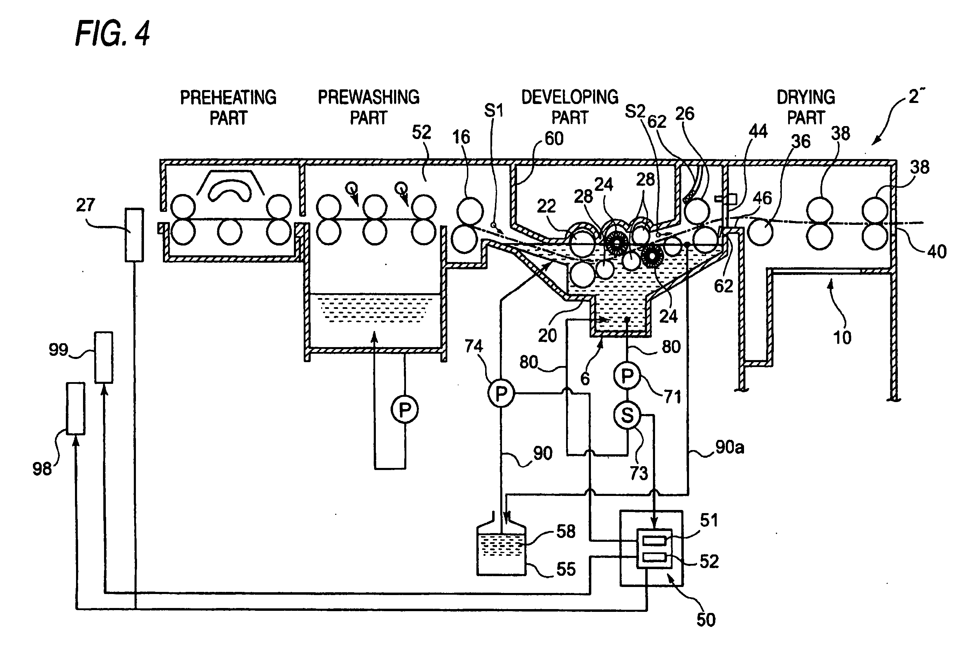

Fig. 4 illustrates a diagram of an automatic processing apparatus 2" according to a third embodiment of the invention. In Fig. 4, members identified with the same numerals as in Fig. 1 may be identical and will not be redundantly described.

The developing part 6 of the apparatus 2" is basically equal to that of Fig. 1, except that a preheating part and a prewashing part are provided upstream of the developing part 6.

The preheating part is provided upstream of the developing part 6 and functions to maintain the surface temperature of a moving PS plate at a specific temperature for a specific time period.

The prewashing part is provided upstream of the developing part 6 and downstream of the preheating part and functions to wash the moving PS plate surface with water to clean and cool it. The PS plate thus cleaned in the prewashing part is forwarded to the next step, the developing part 6.

Incorporating the preheating part and the prewashing part increases the overall size of the apparatus but offers an advantage of improving or stabilizing printing plate qualities, such as press life.

Either one of the preheating part and the prewashing part may be dispensed with.

In the third embodiment, too, the apparatus 2" has an external tank 55, whereby the developer 58 circulates so as to keep the liquid level of the development tank 20 constant. When the entire developer in the development tank 20 and the external tank 55 is 100% exhausted, only the developer of the external tank 55 is replaced, and the development processing is continued. Further, after the developer of the external tank 55 is replaced at least once, the entire developer of both the development tank 20 and the external tank 55 is replaced, and the development processing is continued.

By so doing, the present embodiment makes it feasible to standardize the control on processing capacity and timing of replacement of the developer among users of different scales. This reduces waste of the developer and permits periodical replacement of the entire developer in both the development tank and the external tank of users of different scales all at once, bringing about improved working efficiency.

In the present invention, the lithographic printing plate precursor (PS plate) is imagewise exposed to light of 350 to 450 nm. The exposed plate is abraded with an abrading member in the presence of an aqueous solution (developer) having a pH of 2 to 10, whereby the protective layer and the unexposed area of the photosensitive layer are removed to leave an image layer on the aluminum support.

The aqueous solution used in the invention is preferably an aqueous solution having a pH of 2 to 10. For example, water alone or an aqueous solution containing water as a main ingredient (i.e., in a proportion of 60% by mass or more) is preferred. An aqueous solution having the same composition as a commonly known fountain solution, an aqueous solution containing a surfactant (e.g., an anionic, a nonionic, or a cationic surfactant), or an aqueous solution containing a water soluble polymer (water soluble resin) is more preferred. An aqueous solution containing both a surfactant and a water soluble polymer is particularly preferred. The pH of the aqueous solution is more preferably 4 to 9.5, even more preferably 5 to 9. The surfactant content in the aqueous solution is preferably 1.0 to 15% by mass, more preferably 2.0 to 10% by mass.

Examples of anionic surfactants that can be used in the invention include fatty acid salts, abietic acid salts, hydroxyalkanesulfonic acid salts, alkanesulfonic acid salts, dialkylsufosuccinic acid salts, straight chain alkylenebenzenesulfonic acid salts, branched alkylbenzenesulfonic acid salts, alkylnaphthalenesulfonic acid salts, alkylphenoxypolyoxyethylene propylenesulfonic acid salts, polyoxyethylene alkylsulfophenyl ether salts, N-methyl-N-oleyltaurine sodium salt, N-alkylsufosuccinic acid monoamide disodium salts, petroleum sulfonic acid salts, sulfated castor oil, sulfated beef tallow oil, sulfuric ester salts of fatty acid alkyl esters, alkyl sulfuric ester salts, polyoxyethylene alkyl ether ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partial saponification products of styrene-maleic anhydride copolymers, partial saponification products of olefin-maleic anhydride copolymers, and naphthalenesulfonic acid salt-formalin condensates. Preferred of them are dialkylsulfosuccinic acid salts, alkylsulfuric ester salts, and alkylnaphthalenesulfonic acid salts.

Examples of cationic surfactants that can be used in the invention include, but are not limited to, alkylamine salts, quaternary ammonium salts, polyoxyethylene alkylamine salts, and polyethylene polyamine derivatives.

Examples of nonionic surfactants that can be used in the invention include polyethylene glycol higher alcohol ethylene oxide adducts, alkylphenol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, fat/oil ethylene oxide adducts, polypropylene glycol ethylene oxide adducts, dimethylsiloxane-ethylene oxide block copolymers, dimethylsiloxane-(propylene oxide-ethylene oxide) block copolymers, polyhydric alcohol-type glycerol fatty acid esters, pentaerythritol fatty acid esters, sorbitol/sorbitan fatty acid esters, sucrose fatty acid esters, polyhydric alcohol alkyl ethers, and alkanolamine fatty acid amides.

These nonionic surfactants may be used either individually or as a mixture of two or more thereof. Preferred are sorbitol and/or sorbitan fatty acid ester ethylene oxide adducts, polypropylene glycol ethylene oxide adducts, dimethylsiloxane-ethylene oxide block copolymers, dimethylsiloxane-(propylene oxide-ethylene oxide) block copolymers, and polyhydric alcohol fatty acid esters.

The nonionic surfactant for use in the aqueous solution preferably has an HLB (hydrophile-lipophile balance) of at least 6, more preferably 8 or higher, for its stable solubility in and miscibility with water. In addition, acetylene glycol or acetylene alcohol oxyethylene adducts, fluorine-containing surfactants, and silicon-containing surfactants are also useful.

The aqueous solution in the invention may contain an organic solvent. Organic solvents that may be in the solution includes aliphatic hydrocarbons (e.g., hexane, heptane, Isoper E, H, and G (from Esso Chemical), gasoline, and kerosene), aromatic hydrocarbons (e.g., toluene and xylene), halogenated hydrocarbons (e.g., methylene dichloride, ethylene dichloride, trichlene, and monochlorobenzene), and polar solvents, such as alcohols and esters.

In the case where the organic solvent is insoluble in water, it may be solubilized in water with, for example, a surfactant before it is used. When the aqueous solution contains an organic solvent, the concentration of the organic solvent is preferably less than 40% by weight in view of safety and inflammability.

The aqueous solution may also contain a water soluble polymer. Examples of the water-soluble polymer include soybean polysaccharides, modified starch, gum arabic, dextrin, cellulose derivatives (e.g., carboxymethyl cellulose, carboxyethyl cellulose, and methyl cellulose) and their modified derivatives, pullulan, polyvinyl alcohol and its derivatives, polyvinylpyrrolidone, polyacrylamide, acrylamide copolymers, vinyl methyl ether-maleic anhydride copolymers, vinyl acetate-maleic anhydride copolymers, and styrene-maleic anhydride copolymers.

The soybean polysaccharides for use in the invention may be of any kind known in the art, including commercially available products, such as Soyafibe (by Fuji Oil Co., Ltd.) of various grades. Those having a viscosity of 10 to 100 mPa/sec in a 10 mass% aqueous solution are preferred.

The modified starch to be used in the invention may be of any kind known in the art, which may be produced by decomposing corn, potato, tapioca, rice or wheat-derived starch with an acid or an enzyme to have 5 to 30 glucose residues per molecule and adding thereto propylene oxide in alkali.

The water soluble polymers may be used in combination of two or more thereof. The content of the water soluble polymer in the aqueous solution is preferably 0.1% to 20% by mass, more preferably 1.0% to 15% by mass, even more preferably 2.0% to 10.0% by mass.

Besides the foregoing ingredients, an antiseptic, a chelating compound, an anti-foaming agent, an organic acid, an inorganic acid, an inorganic salt, and so on may be present in the aqueous solution.

Examples of suitable antiseptics include phenol and derivatives thereof, formalin, imidazole derivatives, sodium dehydroacetate, 4-isothiazolin-3-one derivatives, benzisothiazolin-3-one, benzotriazole derivatives, amidineguanidine derivatives, quaternary ammonium salts, pyridine derivatives, quinoline derivatives, guanidine derivatives, diazine, triazole derivatives, oxazole, oxazine derivatives, and bromonitroalcohols, such as 2-bromo-2-nitropropane-1,3-diol, 1,1-dibromo-1-nitro-2-ethanol, and 1,1-dibromo-1-nitro-2-propanol.

Examples of the chelating compound include ethylenediaminetetraacetic acid or a potassium or a sodium salt thereof, diethylenetriaminepentaacetic acid or a potassium or a sodium salt thereof, triethylenetetraaminehexaacetic acid or a potassium or a sodium salt, hydroxyethylethylenediaminetriacetic acid or a potassium or a sodium salt thereof, nitrilotriacetic acid or its sodium salt, and organic phosphonic acid compounds or phosphonoalkanetricarboxylic acid compounds, such as 1-hydroxyethane-1,1-diphosphonic acid or a potassium or a sodium salt thereof, and aminotri (methylenephosphonic acid) or a potassium or a sodium salt thereof. Besides the sodium or potassium salts recited above, organic amine salts are also effective.

Usable anti-forming agents include ordinary silicone anti-foaming agents of self-emulsifiable or emulsifiable type and nonionic surfactants having an HLB of 5 or less. The anti-foaming agent is preferably a silicone anti-foaming agent. Among these anti-foaming agents, either an emulsion dispersion type or solubilized type anti-foaming agent may be used.

Examples of the organic acid includes citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, organic phosphonic acids. The organic acid may also be in the form of its alkali metal salt or ammonium salt.

Examples of the inorganic acid and the inorganic salt include phosphoric acid, metaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexametaphosphate, magnesium sulfate, sodium nitrate, potassium nitrate, ammonium nitrate, sodium sulfate, potassium sulfate, ammonium sulfate, sodium sulfite, ammonium sulfite, sodium hydrogensulfate, and nickel sulfate.

The lithographic printing plate precursor that can be used in the invention will be described.

The lithographic printing plate precursor used in the platemaking process of the invention has a negative-working photosensitive layer that cures in exposed areas. The negative working photosensitive layer is preferably, but not limited to, a radical polymerizable photosensitive layer containing a hydrophobic binder polymer, a polymerization initiator, and a polymerizable compound, in terms of good developability and long press life.

The hydrophobic binder polymer for use in the photosensitive layer is preferably a water insoluble polymer. Further, it is desirable that the hydrophobic binder polymer usable in the invention be substantially free from acid group, such as a carboxyl group, a sulfone group or a phosphoric acid group, and have an acid value (the acid content per gram of the polymer represented by the chemical equivalence) of 0.3 meq/g or less, more preferably 0.1 meq/g or less.

Specifically, the hydrophobic binder polymer used in the invention is preferably insoluble in water and in an aqueous solution having a pH of 10 or more. The solubility of the hydrophobic binder polymer in water or in an aqueous solution at a pH of 10 or more is preferably 0.5% by mass or less, more preferably 0.1% by mass or less. Using such a hydrophobic binder polymer improves the film strength, water resistance, and ink receptivity of the photosensitive layer, thereby improving the press life of the resulting printing plate.

Any hydrophobic binder polymers known in the art may be used as long as the performance of the lithographic printing plate is not impaired, preferably as long as the above mentioned conditions are satisfied. Film-forming, linear organic polymers are preferred.

The hydrophobic binder polymers of the type described are preferably selected from acrylic resins, polyvinyl acetal resins, polyurethane resins, polyamide resins, epoxy resins, methacrylic resins, and styrene resins. More preferred are acrylic resins, particularly (meth)acrylic ester copolymers. Especially preferred are copolymers of an alkyl or aralkyl (meth) acrylate and a (meth) acrylic ester in which R of the ester residue (-COOR) contains a -CH₂CH₂O- unit or a -C₂CH₂NH- unit. The alkyl group in the alkyl (meth)acrylate is preferably an alkyl group having 1 to 5 carbon atoms, more preferably a methyl group. The aralkyl (meth)acrylate is preferably benzyl (meth)acrylate.

The hydrophobic binder polymer may be designed to crosslink to improve the film strength of an image area.

A hydrophobic binder polymer may be made crosslinkable by introducing a crosslinking functional group, such as an ethylenically unsaturated bond, into the main chain or the side branch of the polymer. The crosslinking functional group may be introduced through copolymerization or through polymeric reaction.

The crosslinking group is a group capable of crosslinking the polymer binder in the process of radical polymerization reaction that occurs in the photosensitive layer when the lithographic printing plate precursor is exposed to light. Any group serving for the function may be used. For example, the group may be an addition-polymerizable functional group, such as an ethylenically unsaturated bond group, an amino group, or an epoxy group. It may also be a functional group capable of giving a radical on irradiation, such as a thiol group, a halogen group, or an onium salt structure. Above all, preferred is an ethylenically unsaturated bond group, particularly, a functional group represented by formulae (1) to (3) shown below. 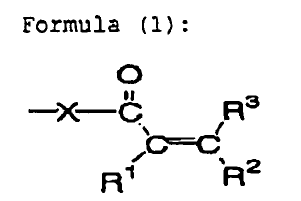 wherein R¹, R², and R³ each represent a hydrogen atom or a monovalent organic group; X represents an oxygen atom, a sulfur atom, or N(R¹²)-; and R¹² represents a hydrogen atom or a monovalent organic group.

R¹ is preferably a hydrogen atom or an alkyl group optionally having a substituent. R¹ is more preferably a hydrogen atom or a methyl group for its high radical reactivity. R² and R³ each preferably represent a hydrogen atom, a halogen atom, an amino group, a carboxyl group, an alkoxycarbonyl group, a sulfo group, a nitro group, a cyano group, an alkyl group optionally having a substituent, an aryl group optionally having a substituent, an alkoxy group optionally having a substituent, an aryloxy group optionally having a substituent, an alkylamino group optionally having a substituent, an arylamino group optionally having a substituent, an alkylsulfonyl group optionally having a substituent, or an arylsulfonyl group optionally having a substituent, more preferably a hydrogen atom, a carboxyl group, an alkoxycarbonyl group, an alkyl group optionally having a substituent, or an aryl group optionally having a substituent for their high radical reactivity.

The organic group as represented by R¹² is exemplified by an alkyl group optionally having a substituent. X is preferably a hydrogen atom, a methyl group, an ethyl group, or an isopropyl group for their high radical reactivity.

Examples of the substituents that may be present in the above described organic groups includes an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, and an arylsulfonyl group. 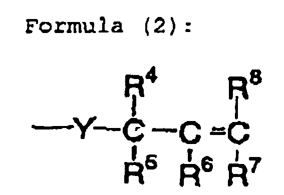 wherein R⁴, R⁵, R⁶, R⁷, and R⁸ each represent a hydrogen atom or a monovalent organic group; Y represents an oxygen atom, a sulfur atom, or N(R¹²)-; and R¹² is as defined for formula (1).

R⁴, R⁵, R⁶, R⁷, and R⁸ each preferably represent a hydrogen atom, a halogen atom, an amino group, a dialkylamino group, a carboxyl group, an alkoxycarbonyl group, a sulfo group, a nitro group, a cyano group, an alkyl group optionally having a substituent, an aryl group optionally having a substituent, an alkoxy group optionally having a substituent, an aryloxy group optionally having a substituent, an alkylamino group optionally having a substituent, an arylamino group optionally having a substituent, an alkylsulfonyl group optionally having a substituent, or an arylsulfonyl group optionally having a substituent, more preferably a hydrogen atom, a carboxyl group, an alkoxycarbonyl group, an alkyl group optionally having a substituent, or an aryl group optionally having a substituent.

The examples of the substituents that may be present in the organic groups are the same as those described with respect to formula (1). Preferred examples of R¹² are also the same as those described above. 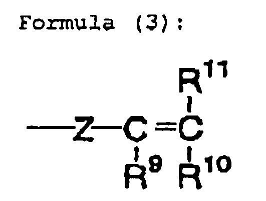 wherein R⁹ is preferably a hydrogen atom or an alkyl group optionally having a substituent, more preferably a hydrogen atom or a methyl group for its high radical reactivity; R¹⁰ and R¹¹ each preferably represent a hydrogen atom, a halogen atom, an amino group, a dialkylamino group, a carboxyl group, an alkoxycarbonyl group, a sulfo group, a nitro group, a cyano group, an alkyl group optionally having a substituent, an aryl group optionally having a substituent, an alkoxy group optionally having a substituent, an aryloxy group optionally having a substituent, an alkylamino group optionally having a substituent, an arylamino group optionally having a substituent, an alkylsulfonyl group optionally having a substituent, or an arylsulfonyl group optionally having a substituent, more preferably a hydrogen atom, a carboxyl group, an alkoxycarbonyl group, an alkyl group optionally having a substituent, or an aryl group optionally having a substituent because of their radical reactivity thereof.

Examples of the substituents that may be present in the organic groups recited are the same as those in formula (1). Z represents an oxygen atom, a sulfur atom, -N(R¹³), or a phenylene group optionally having a substituent. R¹³ preferably represents an alkyl group optionally having a substituent. R¹³ more preferably represents methyl, ethyl, or isopropyl for their high radical reactivity.

Of the crosslinking hydrophobic binder polymers described above, preferred are (meth)acrylic acid copolymers and polyurethanes having a crosslinking group in the side branch thereof.

The crosslinking hydrophobic binder polymer cures, for example, as follows. A free radical (a polymerization initiating radical or a radical growing in the process of polymerization of a polymerizable compound) adds to the crosslinking functional group of the polymer to induce addition polymerization between the polymer molecules either directly or via the polymerization chain of the polymerizable compound, whereby a crosslink is formed between the polymer molecules, and the polymer cures. Otherwise, an atom of the polymer molecules (for example, a hydrogen atom on the carbon atom adjacent to the functional crosslinking group) is pulled out by a free radical to form polymer radicals, which bond to each other to form a crosslink between the polymer molecules. The polymer thus cures.

The content of the crosslinking group in the hydrophobic binder polymer (the radical-polymerizable unsaturated double bond content measured by iodine titration) is preferably 0.1 to 10.0 mmol, more preferably 1.0 to 7.0 mmol, even more preferably 2. 0 to 5.5 mmol, per gram of the hydrophobic binder polymer.

From the viewpoint of improving the developability in an aqueous solution, the binder polymer is preferably hydrophilic. From the viewpoint of improving the press life, it is important that the binder polymer is compatible with the polymerizable compound present in the photosensitive layer, that is, the polymer is preferably lipophilic. For these considerations, it may be effective to copolymerize a hydrophilic group and a lipophilic group in the hydrophobic binder polymer for improving both the developability and the press life. Examples of the hydrophilic group include a hydroxyl group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group, and a carboxymethyl group.

The hydrophobic binder polymer preferably has a weight average molecular weight (Mw) of at least 5000, more preferably 10,000 to 300,000, a number average molecular weight (Mn) of at least 1000, more preferably 2000 to 250, 000, and a molecular weight distribution (Mw/Mn) of 1.1 to 10.

The hydrophobic binder polymer may be any of a random polymer, a block polymer, a graft polymer, and the like but is preferably a random polymer.

The hydrophobic binder polymers may be used either individually or in combination of two or more thereof.

The content of the hydrophobic binder polymer may be from 5% to 90%, preferably 10% to 70%, more preferably 10% to 60%, by mass relative to the total solids content of the photosensitive layer. Within the range, the photosensitive layer exhibits good strength of its image area and good image forming properties.

The polymerization initiator that can be used in the photosensitive layer is a compound capable of generating a radical by light or heat energy, thereby initiating and promoting polymerization of a compound having a polymerizable unsaturated group. Such a radical initiator is selected appropriately from known polymerization initiators, compounds with a bond having a low bond dissociation energy, and the like.

Examples of the radical generating compound (radical initiator) include organic halogen compounds, carbonyl compounds, organic peroxides, azo polymerization initiators, azide compounds, metallocene compounds, hexaarylbiimidazole compounds, organic boron compounds, disulfone compounds, oxime ester compounds, and onium salt compounds.

Examples of the organic halogen compounds are described, e.g., in Wakabayashi, et al., Bull. Chem. Soc. Japan, 42, 2924 (1969), U.S. Patent 3,905,815, JP 46-4605B, JP 48-36281A, JP 53-133428A, JP 55-32070A, JP 60-239736A, JP 61-169835A, JP 61-169837A, JP 62-58241A, JP 62-212401A, JP 63-70243A, JP 63-298339A, and M. P. Hutt, Journal of Heterocyclic Chemistry, 1, No. 3 (1970). Especially preferred are trihalomethyl-substituted oxazole compounds and S-triazine compounds.

Examples of the carbonyl compounds include benzophenone, Michler's ketone, 2-methylbenzophenone, 3-methylbenzophenone, 4-methylbenzophenone, 2-chlorobenzophenone, and 4-bromobenzophenone.

Examples of the azo compounds are given, e.g., in JP 8-108621A.

The metallocene compounds are exemplified by various titanocene compounds described in JP 59-152396A, JP 61-151197A, JP 63-41484A, JP 2-249A, JP 2-4705A, JP 5-83588A and iron-arene complexes described in JP 1-152109A.

The hexaarylbiimidazole compounds are exemplified by the various compounds described in JP 6-29285B and U.S. Patent Nos. 3,479,185, 4,311,783, and 4,622,286.

Examples of the organic boron compounds include organic boric acid salts described in JP 2002-116539A and Kunz, Martin, Rad. Tech., '98, Proceeding Apr., 19-22, 1998, Chicago; organic boron sulfonium complexes or organic boron oxosulfonium complexes described in JP 6-157623A, JP 6-175564A, JP 6-175561A; organic boron iodonium complexes described in JP 6-175554A, JP 6-175553A; organic boron phosphonium complexes described in JP 9-188710A; and organic boron transition metal coordination complexes described in JP 6-348011A, JP 7-128785A, JP 7-140589A, JP 7-306527A, and JP 7-292014A.

Examples of the disulfone compounds are described in JP 61-166544A and JP 2003-328465A.

Examples of the oxime ester compounds are described in J.C.S. Perkin II (1979) 1653-1660, J.C.S. Perkin II (1979) 156-162, Journal of Photopolymer Science and Technology (1995) 202-232, JP 2000-66385A, and JP 2000-80068A.

Examples of the onium salt compounds include diazonium salts described in S. I. Schlesinger, Photogr. Sci. Eng., 18, 387 (1974), T. S. Bal et al., Polymer, 21, 423 (1980); ammonium salts described in U.S. Patent No. 4,069,055 and JP 4-365049A; phosphonium salts described in U.S. Patent Nos. 4,069,055 and 4, 069, 056; iodonium salts described in EP 104, 143, U.S. Patent Nos. 339,049 and 410,201, JP 2-150848A, and JP 2-296514A; sulfonium salts described in EP No. 370693, 390214, 233567, 297443, and 297442, U.S. Pat. No. 4,933,377, 161,811, 410,201, 339,049, 4,760,013, 4,734,444, and2,833,827, German Patent Nos. 2,909,626, 3,604,580, and 3,604,581; selenonium salts described in J. V. Crivello et al. , Macromolecules, 10 (6), 1307 (1997), and J. V. Crivello et al. , J. Polymer Sci., Polymer Chem. Ed., 17, 1047 (1979) ; and arsonium salts described in C. S. Wen et al., Teh. Proc. Conf. Rad. Curing ASIA, p. 478, Tokyo, Oct. (1988).

In the invention, these onium salts does not function as an acid generator but as an ionic radical polymerization initiator.

Onium salts represented by formulae (RI-I) to (RI-III) below are preferably used in the invention.

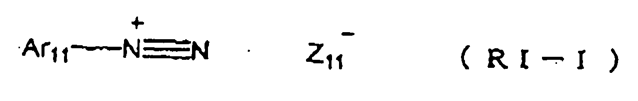

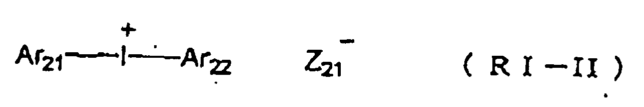

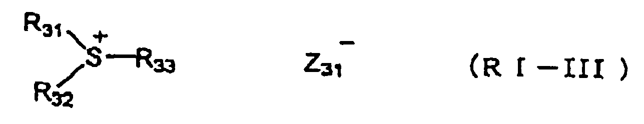

In formula (RI-I), R₁₁ represents an aryl group having 20 or fewer carbon atoms and optionally having 1 to 6 substituents; and Z₁₁⁻ represents a monovalent anion. From the safety point of view, Z₁₁⁻ is preferably a perchlorate ion, a hexafluorophosphate ion, a tetrafluoroborate ion, a sulfonate ion, a sulfinate ion or carboxylate ion.

In formula (RI-II), Ar₂₁ and Ar₂₂ each represent an aryl group having 20 or fewer carbon atoms and optionally having 1 to 6 substituents; and Z₂₁⁻ represents a monovalent anion. Examples of preferred substituents include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamide or arylamido group having 1 to 12 carbon atoms, a carbonyl group, a carboxyl group, a cyano group, a sulfonyl group, a thioalkyl group having 1 to 12 carbon atoms, and a thioaryl group having 1 to 12 carbon atoms. The anion as Z₂₁⁻ is preferably a perchlorate ion, a hexafluorophosphate ion, a tetrafluoroborate ion, a sulfonate ion, a sulfinate ion, or carboxylate ion in terms of stability and reactivity.

In formula (RI-II), R₃₁, R₃₂, and R₃₃ each represent an aryl, alkyl, alkenyl, or alkynyl group having 20 or fewer carbon atoms and optionally having from 1 to 6 substituents, Z₃₁⁻ represents a monovalent anion. R₃₁, R₃₂, and R₃₃ each preferably represent an aryl group in terms of reactivity and the stability. The anion as Z₃₁⁻ is preferably a perchlorate ion, a hexafluorophosphate ion, a tetrafluoroborate ion, a sulfonate ion, a sulfinate ion, or carboxylate ion in terms of stability and reactivity. More preferably, Z₃₁⁻ is a carboxylate ion described in JP 2001-343742A, even more preferably a carboxylate ion described in JP 2002-148790A.

Examples of the polymerization initiator that can be used in the invention include, but are not limited to, triazine initiators, organic halogen compounds, oxime ester compounds, diazonium salts, iodonium salts, and sulfonium salts from the viewpoint of reactivity and stability.

The polymerization initiators may be used either individually or in combination of two or more thereof.

The polymerization initiator may be present in the layer that contains the other components or a separate layer additionally provided. The amount of the polymerization initiator to be used is preferably 0.1% to 50%, more preferably 0.5% to 30%, even more preferably 0.8% to 20%, by mass relative to the total solids content of the photosensitive layer.

In the cases where the lithographic printing plate precursor is designed to be imagewise exposed to infrared light, the photosensitive layer may contain, in combination with the polymerization initiator, an IR absorber. An IR absorber generally has a function of converting IR rays it has absorbed into heat, and the resulting heat thermally decomposes the polymerization initiator to produce a radical. The IR absorber for use in the invention is a dye or pigment having an absorption maximum in a wavelength range of from 760 to 1200 nm.

Commercially available dyes and dyes known from literature, for example, dyes described in senryo Binran (edited by the Association of Organic Synthetic Chemistry of Japan) (1970) may be used, including azo dyes, metal complex azo dyes, pyrazolone azo dyes, naphthoquinone dyes, anthraquinone dyes, phthalocyanine dyes, carbonium dyes, quinonimine dyes, methine dyes, cyanine dyes, squarylium dyes, pyrylium salts, and metal thiolate complexes.

Preferred of these dyes are cyanine dyes, squarylium dyes, pyrylium salts, nickel thiolate complexes, and indolenine cyanine dyes.

The pigments usable in the invention include commercially available pigments and pigments described in Color Index (C.I.) Binran, Saishin Ganryo Binran (edited by Nihon Ganryo Gijyutu Kyokai) (1977), Saishin Ganryo Ohyogijutsu, CMC Publishing Co., Ltd. (1986), and Insatsu Ink Gijutsu, CMC Publishing Co., Ltd. (1984).

Useful pigments include black pigments, yellow pigments, orange pigments, brown pigments, red pigments, violet pigments, blue pigments, green pigment, fluorescent pigments, metal powder pigments, and polymer-bound pigments. More specifically, useful pigments include insoluble azo pigments, azo lake pigments, condensed azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black. Preferred of them is carbon black.

The particle size of the pigment is preferably 0.01 to 10 µm, more preferably 0.05 to 1 µm, even more preferably 0.1 to 1 µm. Within the range, a dispersion of the pigment is stable in a coating composition for photosensitive layer and gives a uniform photosensitive layer.

It is desirable that the amount of the IR absorber to be added to the photosensitive layer be limited to the necessary minimum to prevent inhibition on polymerization reaction.

The IR absorber may be present in the photosensitive layer in an amount of 0.001% to 50%, preferably 0.005% to 30%, more preferably 0.01% to 10%, by mass relative to the total solids content of the layer. Within the range recited, improved sensitivity is provided without giving adverse influences on the uniformity and film strength of the photosensitive layer.

In the cases where the lithographic printing plate precursor is designed to be imagewise exposed to light of 250 to 420 nm, the photosensitive layer may contain, in combination with the polymerization initiator, a sensitizing dye, thereby to increase the radical generation efficiency of the initiator.

Examples of the sensitizing dye are benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthane, benzil, dibenzalacetone, p-(dimethylamino)phenyl styryl ketone, p-(dimethylamino)phenyl p-methylstyryl ketone, benzophenone, p-(dimethy7.amino)benzophenone (or Michler's ketone), p-(diethylamino)benzophenone, benzanthrone, and 2,5-bis(4-diethylaminophenyl)-1,3,4-oxadiazole.

The sensitizing dye may be added to the photosensitive layer preferably in an amount of 0.1% to 50%, more preferably 0.5% to 30%, even more preferably 0.8 to 20%, by mass relative to the total solids content of the photosensitive layer.

The polymerizable compound that can be used in the photosensitive layer is an addition-polymerizable compound having at least one ethylenically unsaturated double bond, which is selected from compounds having at least one, preferably at least two terminal ethylenically unsaturated bonds. This type of compounds are widely known in the art, and any of them is usable in the invention. These compounds may have a chemical form of a monomer or a prepolymer (i.e., dimer, trimer, and oligomer), or a mixture or a copolymer thereof. Examples of the monomers (and copolymers) are unsaturated carboxylic acids (e.g., acrylic acid, methacrylic acid, itaconic acid, crotonic acid, isocrotonic acid, and maleic acid), and their esters and amides. Esters of unsaturated carboxylic acids and aliphatic polyalcohol compounds and amides of unsaturated carboxylic acids and aliphatic polyamine compounds are preferred. Also preferred are addition reaction products of unsaturated carboxylic acid esters or amides having a nucleophilic substituent, such as a hydroxyl group, an amino group or a mercapto group, and monofunctional or polyfunctional isocyanates or epoxides; dehydration/condensation products thereof with monofunctional or polyfunctional carboxylic acids; addition reaction products of unsaturated carboxylic acid esters or amides having an electrophilic substituent, such as an isocyanate group or an epoxy group, and monofunctional or polyfunctional alcohols, amines or thiols; and substitution reaction products of unsaturated carboxylic acid esters or amides having a leaving substituent, such as a halogen group or a tosyloxy group, and monofunctional or polyfunctional alcohols, amines or thiols. Also usable are a group of compounds derived from the above compounds by substituting the unsaturated carboxylic acids with unsaturated phosphonic acids, styrene, vinyl ether or the like.

Part of each of the above described components forming the photosensitive layer and/or other components mentioned below may be incorporated into the photosensitive layer in the form of microcapsules, as taught, e.g., in JP 2001-277740A and JP 2001-277742A. In this case, the component may be present inside and outside the microcapsules in any ratio.

The microcapsule wall preferred for use in the invention has a three-dimensional crosslinked structure and has a property of swelling with solvent. From this viewpoint, the microcapsule wall material is preferably polyurea, polyurethane, polyester, polycarbonate, polyamide and mixtures thereof, with polyurea and polyurethane being particularly preferred. If desired, a compound having the above-mentioned crosslinking functional group, such as an ethylenically unsaturated bond, which may be introduced into the water-insoluble polymer, may be introduced into the microcapsule wall.

The average particle size of the microcapsules is 0.01 to 3.0 µm, more preferably 0.05 to 2.0 µm, even more preferably 0.10 to 1.0 µm. Within the range recited, good resolution and stability with time are secured.

Where necessary, the photosensitive layer of the invention may contain various additives as hereinafter described.

The photosensitive layer preferably contains a surfactant to accelerate the development and improve the coating surface conditions. Nonionic, anionic, cationic, or amphoteric surfactants, fluorine-containing surfactants, and the like are useful. The surfactants may be used either individually or in combination of two or more thereof.

The photosensitive layer may contain a hydrophilic polymer to improve developability and improve dispersion stability of microcapsules.

Preferred hydrophilic polymers are those having a hydrophilic group, such as a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, or a phosphoric acid group.

The hydrophilic polymer preferably has a weight average molecular weight of at least 5000, more preferably 10,000 to 300,000. The hydrophilic polymer may be any of a random polymer, a block polymer, and a graft polymer.

The content of the hydrophilic polymer in the photosensitive layer is preferably not more than 20%, more preferably 10% or less, by mass of the total solids content of the layer.

A dye having strong absorption in the visible region may be present in the photosensitive layer as an image colorant. Examples of useful dyes include Oil Yellow #101, Oil Yellow #103, Oil Pink #312, Oil Green BG, Oil Blue BOS, Oil Blue #603, Oil Black BY, Oil Black BS, Oil Black T-505 (all by Orient Chemical Industry); Victoria Pure Blue, Crystal Violet (CI 42555), Methyl Violet (CI 42535), Ethyl Violet, Rhodamine B (CI 145170B), Malachite Green (CI 42000), Methylene Blue (CI 52015); and dyes described in JP 62-293247A. Pigments, including phthalocyanine pigments, azo pigments, carbon black, and titanium oxide, are also suited as an image colorant.

Addition of such a colorant is recommended to make the image area more distinct from the non-image area after development. The amount of the colorant to be added is preferably 0.01% to 10% by mass based on the total solids content of the image-recording material.

### (Printing-out agent)

A compound that changes in color in the presence of an acid or a radical may be added to the photosensitive layer to visualize an exposed area (image area). Various dyes effectively serve therefor, including diphenylmethane dyes, triphenylmethane dues, thiazine dyes, oxazine dyes, xanthene dyes, anthraquinone dyes, iminoquinone dyes, azo dyes, and azomethine dyes.

A suitable amount of the dye that changes its color by an acid or a radical is 0.01% to 15% by mass relative to the solids content of the photosensitive layer.

The photosensitive layer preferably contains a small amount of a thermal polymerization inhibitor to prevent unnecessary thermal polymerization of the radical polymerizable compound in the layer during production or storage of the photosensitive layer.

Examples of preferred thermal polymerization inhibitors are hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salt.

The amount of the thermal polymerization inhibitor to be added is preferably about 0.01% to about 5% by mass relative to the total solids content of the photosensitive layer.

A higher fatty acid compound, such as behenic acid or behenamide, may be present in a coating composition for photosensitive layer and, after application, be localized on the surface of the photosensitive layer during the drying step to prevent polymerization inhibition by oxygen. The amount of the compound to be added is preferably about 0.1 to about 10% by mass based on the total solids content of the photosensitive layer.

The photosensitive layer can contain a plasticizer. Examples of suitable plasticizers include phthalates, such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, and diallyl phthalate; glycol esters, such as dimethyl glycol phthalate, ethylphthalylethyl glycolate, methylphthalylethyl glycolate, butylphthalylbutyl glycolate, and triethylene glycol dicaprylate; phosphoric esters, such as tricresyl phosphate and triphenyl phosphate; aliphatic dibasic acid esters, such as diisobutyl adipate, dioctyl adipate, dimethyl sebacate, dibutyl sebacate, dioctyl azelate, and dibutyl maleate; polyglycidyl methacrylate, triethyl citrate, triacetyl glycerol, and butyl laurate. The content of the plasticizer is preferably about 30% by mass or less relative to the total solids content of the photosensitive layer.

The photosensitive layer may contain inorganic particles to improve cured film strength in the image area. Examples of preferred inorganic particles include particles of silica, alumina, magnesium oxide, titanium oxide, magnesium carbonate, and calcium alginate, and their mixtures. Even though they are incapable of photothermal conversion, they serve for film strengthening and for surface roughening for interfacial adhesion enhancement. The inorganic particles preferably have an average particle size of 5 nm to 10 µm, more preferably 0.5 to 3 µm. Within the range recited, the particles disperse stably in the photosensitive layer to maintain sufficient film strength of the image area and to form a highly water wettable non-image area that is less likely to cause background stains during printing.

The inorganic particles are easily available as commercial products, such as a colloidal silica dispersion. The content of the inorganic particles is preferably not more than 20% by mass, more preferably 10% by mass or less, relative to the total solids content of the photosensitive layer.

The photosensitive layer in the invention may contain a hydrophilic low-molecular compound to have improved developability. The hydrophilic low-molecular compound may be a water-soluble organic compound. Examples of the water soluble organic compound include glycols, such as ethylene glycol, diethylene glycol, triethylene glycol, propylene glycol, dipropylene glycol, and tripropylene glycol, and their ether or ester derivatives; polyhydroxy compounds, such as glycerol and pentaerythritol; organic amines, such as triethanolamine, diethanolamine, and monoethanolamine, and their salts; organic sulfonic acids, such as toluenesulfonic acid and benzenesulfonic acid, and their salts; organic phosphonic acids, such as phenylphosphonic acid, and their salts; organic carboxylic acids, such as tartaric acid, oxalic acid, citric acid, malic acid, lactic acid, gluconic acid, and amino acids, and their salts; and organic quaternary ammonium salts, such as tetraethylammonium chloride.

The photosensitive layer may further contain a co-sensitizer.

The photosensitive layer is formed by dispersing or dissolving the above-mentioned necessary components in a solvent to prepare a coating composition and applying it to a support. Examples of useful solvents include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, toluene, and water. These solvents may be used either individually or in combination thereof. The concentration of the coating composition is preferably 1% to 50% by mass.

The photosensitive layer may be formed by repeating application followed by drying using two or more coating compositions which may be either the same or different in composition of the solid components and/or kind of the solvent.

The coating composition is applied usually to a dry thickness of 0.3 to 3.0 g/m², while varying according to the intended use. Within the range recited, the photosensitive layer exhibits good sensitivity and good film properties.

Various coating methods may be employed, including bar coating, spin coating, spray coating, curtain coating, dip coating, air knife coating, blade coating, and roll coating.

It is preferred to provide a protective layer (oxygen barrier layer) on the photosensitive layer to protect the photosensitive layer against diffusive invasion of oxygen that would otherwise interfere with polymerization during exposure to light. The protective layer preferably has an oxygen permeability A of 1.0 to 20 ml/m²·day at 25°C under atmospheric pressure (10≤A≤20(ml/m²·day). When the oxygen permeability A is extremely lower than 1.0 ml/m²·day, there is likelihood that unwanted polymerization occurs during the manufacture and storage of an unexposed printing plate precursor and that unnecessary fogging or line thickening occurs during imagewise exposure. When the oxygen permeability A is as large as exceeding 20 ml/m²·day, the protective layer may cause reduction of sensitivity of the photosensitive layer. The range of oxygen permeability A is more preferably 1.5≤A≤12 (ml/m²·day), even more preferably 2.0≤A≤10.0 (ml/m²·day). Besides the oxygen permeability, properties the protective layer is required to have are: to cause substantially no hindrance to transmission of light for exposure, to have good adhesion to the photosensitive layer, and to be easily removable in the development step after exposure. To achieve these requirements, various manipulations have been made to the protective layer, as suggested in U.S. Patent 3,458,311 and JP 55-49729B.

The protective layer is preferably made of, for example, a water soluble polymer having relatively high crystallinity, such as polyvinyl alcohol, a vinyl alcohol-vinyl phthalate copolymer, a vinyl acetate-vinyl alcohol-vinyl phthalate copolymer, a vinyl acetate-crotonic acid copolymer, polyvinylpyrrolidone, acidic celluloses, gelatin, gum arabic, polyacrylic acid, and polyacrylamide. These water soluble polymers may be used either individually or in combination. Using polyvinyl alcohol as a main component to form the protective layer gives best results of basic characteristics, such as oxygen barrier properties and removability in development.

An inorganic layered compound may be present in the protective layer to improve oxygen barrier properties and provide improved surface protection. The inorganic layered compound as referred to herein is a particulate compound having a thin and tabular shape, exemplified by a mica group mineral, such as natural or synthetic mica represented by formula: A(B,C)₂₋₅D₄O₁₀(OH, F, O)₂, wherein A is K, Na or Ca; B and C are each Fe(II), Fe (III), Mn, Al, Mg, or V; and D is Si or Al; talc represented by formula: 3MgO·4SiO·H₂O; taeiniolite, montmorillonite, saponite, hectorite, and zirconium phosphate.

The natural mica group minerals include muscovite, paragonite, phlogopite, biotite, lepidolite. Examples of the synthetic mica includes non-swelling mica, such as fluorophlogopite KMg₃(AlSi₃O₁₀)F₂ and potassium tetrasilicic mica KMg_{2.5}(Si₄O₁₀)F₂, and swelling mica, such as sodium tetrasilicic mica NaMg_{2.5}(Si₄O₁₀)F₂, Na or Li taeiniolite (Na,Li)Mg₂Li(Si₉O₁₀)F₂, and montmorillonite type Na or Li hectorite (Na,Li)_{1/8}Mg_{2/5}Li_{1/8}(Si₄O₁₀)F₂. Synthetic smectite is also useful.

The inorganic layered compound for use in the invention has an average particle length of 0.3 to 20 µm, preferably 0.5 to 10 µm, more preferably 1 to 5 µm, and an average thickness of 0.1 µm or smaller, preferably 0.05 µm or smaller, more preferably 0.01 µm or smaller. For instance, the particle length and thickness of swelling synthetic mica, a typical compound of the inorganic layered compound, are about 1 to 50 nm and about 1 to 20 µm, respectively.

A coating composition for protective layer containing the components described above is applied to the photosensitive layer formed on a support and dried to form a protective layer. The coating solvent is selected as appropriate to the binder used. When a water soluble polymer is used, distilled water or pure water is preferably used. Any known coating method is used to make the protective layer, including the methods taught in U.S. Patent 3,458,311 or JP 55-99729B. Examples of the coating methods are blade coating, air knife coating, gravure coating, roll coating, spray coating, dip coating, and bar coating.

The coating composition for protective layer is preferably applied to a coating weight of 0.05 to 10 g/m². In the case where the composition contains an inorganic layered compound, the coating weight is more preferably 0.1 to 0.5 g/m². In the case of using a coating composition free from an inorganic layered compound, the coating weight is more preferably 0.5 to 5 g/m².

The support for use in the lithographic printing plate precursor of the invention is not particularly limited, and any sheeting having hydrophilic properties and dimensional stability can be used. Examples of the support include paper, paper laminated with a plastic film (e.g., polyethylene, polypropylene, or polystyrene), metal plates (e.g., aluminum, zinc, or copper), plastic films (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetal), and paper or plastic films laminated or deposited with the above-mentioned metal. A polyester film and an aluminum plate are preferred. An aluminum plate is the best for its good dimensional stability and relative inexpensiveness.

The thickness of the support is preferably 0.1 to 0. 6 mm, more preferably 0.15 to 0.4 mm, even more preferably 0.2 to 0.3 mm.

An aluminum plate is subjected to surface roughening by various methods, including mechanical graining, electrochemical graining (electrochemical dissolution of the surface), and chemical graining (selective chemical dissolution of the surface).

The mechanical graining is carried out by any known method, for example, ball polishing, brush polishing, blast polishing, or buff polishing.

The electrochemical graining is carried out, for example, in an electrolytic solution containing an acid, such as hydrochloric acid or nitric acid, with an alternating current or a direct current. The method of using a mixed acid taught in JP 54-63902A is also effective.

The grained aluminum plate is, if desired, subjected to alkali etching in an aqueous solution of potassium hydroxide or sodium hydroxide, followed by neutralization. Where necessary, the grained aluminum plate may further be subjected to anodizing to have improved abrasion resistance.

Any electrolyte capable of forming a porous oxide film may be used in anodizing an aluminum plate. Sulfuric acid, hydrochloric acid, oxalic acid, chromic acid or a mixture thereof is usually used. The concentration of the electrolyte is determined appropriately depending on the electrolyte.

The conditions of anodizing shall not be indiscriminately discussed, as varying depending on the electrolyte used. In general, however, the conditions are preferably as follows: an electrolyte concentration of 1% to 80% by mass, a solution temperature of 5 to 70°C, a current density of 5 to 60 A/dm², a voltage of 1 to 100 V, and an electrolysis time of 10 seconds to 5 minutes. The amount of the anodized layer formed is preferably 1.0 to 5.0 g/m², more preferably from 1.5 to 4.0 g/m², Within the above range, the resulting lithographic printing plate will have a long press life and good scratch resistance on its non-image area.

A support having been grained and anodized as described may be used as it is, but it may be further processed where further improvement is desired in adhesion to the overlying layer, water wettability, resistance to smearing, heat insulating properties, and so forth. Treatment for further processing is suitably selected from a treatment for enlarging micropores in the anodized layer, a treatment for sealing the micropores, a treatment for surface hydrophilization by dipping a support in an aqueous solution containing a hydrophilic compound, and other treatments. The enlarging or sealing micropores of an anodized layer may be carried out by, though not exclusively, the methods described in JP 2001-253181 and JP 2001-322365.

The hydrophilization treatment may be an alkali metal silicate method as described in U.S. Patents 2,714,066, 3,181,461, 3,280,734, and 3,902,734, in which a support is immersed or electrolyzed in an aqueous solution, e.g., of sodium silicate. A method of processing with potassium fluorozirconate as in JP 36-22063B and a method of processing with polyvinylphosphonic acid as in U.S. Patents 3,276,868, 4,153,461, and 4,689,272 are also effective.

It is preferred that the support be provided with an undercoat layer of a compound containing a polymerizable group. When an undercoat layer is provided, the photosensitive layer is formed on the undercoat layer. The undercoat layer is to enhance the adhesion between the support and the photosensitive layer in the exposed area and facilitate peeling of the photosensitive layer from the support in the non-exposed area, thereby improving the developability.

The undercoat layer is preferably of a silane coupling agent having an addition-polymerizable ethylenic double bond reactive group as in JP 10-282679A or a phosphorus compound having an ethylenic double bond reactive group as in JP 2-304441A. Especially preferred is a compound having a polymerizable group, such as a methacryl group or an allyl group, and a group adsorptive to the support (a support adsorptive group), such as a sulfonic acid group, a phosphoric acid group or a phosphoric ester group. Also preferred is a compound having a hydrophilicity-imparting group, such as an ethylene oxide group, in addition to the polymerizable group and the support adsorptive group.

The coating weight (solid basis) of the undercoat layer is 0.1 to 100 mg/m², more preferably 1 to 30 mg/m².

If needed, the support having been surface-treated or coated with an undercoat layer is provided with a backcoat layer on the reverse side thereof.

The backcoat layer is preferably of an organic polymer as in JP 5-45885A or a metal oxide obtained through hydrolysis and polycondensation of an organic metal compound or an inorganic metal compound as in JP 6-35174A. Preferred is a silicon alkoxide compound, such as Si(OCH₃)₄, Si (OC₂H₅)₄, Si(OC₃H₇)₄, Si(OC₄H₉)₄, as its starting materials are inexpensive and readily available.

### REFERENCE EXAMPLE

### (1) Automatic processing apparatus

An automatic processing apparatus TOPLINE OE40 from Haase (Germany) equipped with a 92 liter volume development tank (main tank) was modified by adding an external developer tank having a capacity of 8 liters to give a total capacity of 100 liters. The pumps for circulation fitted to the external tank and the main development tank each had a capacity of 200 cc.

### (2) Preparation of developer

An aqueous solution as a developer was prepared according to the following formulation. The developer had a pH of 4.3.

### Developer Formulation:

| | |
|---|---|
| Water | 8970 g |
| Anionic surfactant of formula: | 400 g |
| 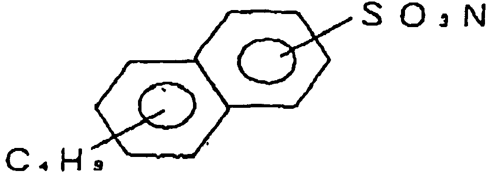 | |
| Gum arabic | 150 g |
| Enzyme-modified potato starch | 400 g |
| Sodium dioctyl sulfosuccinate | 50 g |
| Ammonium primary phosphate | 10 g |
| Citric acid | 10 g |
| EDTA 4Na | 10 g |
| pH: 4.3 | |

### (3) Preparation of lithographic printing plate precursor

### (3-1) Preparation of support

A 0.3 mm thick aluminum plate (material: 1050) was degreased with a 10% (by mass, hereinafter the same) aqueous solution of sodium aluminate at 50°C for 30 seconds to remove roll-mill lubricant from the surface. The aluminum plate was then grained using an aqueous pumice slurry (median diameter: 25 µm; specific gravity: 1.1 g/cm³) and three nylon brushes (implanted bristle thickness: 0.3 mm), followed by thoroughly washing with water. The grained aluminum plate was etched by immersion in a 25% aqueous solution of sodium hydroxide at 45°C for 9 seconds, washed with water, immersed in 20% nitric acid at 60°C for 20 seconds, and washed with water. The amount of aluminum dissolved by the etching was about 3 g/m².

The etched aluminum plate was further grained by continuous electrochemical surface graining in a 1% aqueous solution of nitric acid containing 0.5% aluminum ion (electrolytic solution) at 50°C using an alternating voltage of 60 Hz. The alternating current waveform was a trapezoidal rectangular waveform with the time TP from the current level of zero to the peak of 0.8 msec and a duty ratio of 1:1. A carbon electrode was used as the counter electrode, and ferrite was used as an auxiliary anode. The current density at the peak was 30 A/dm². Five percent of the electric current from the current source was distributed to the auxiliary electrode. The quantity of electricity when the aluminum plate acted as an anode was 175 C/dm². The electrochemically grained aluminum plate was then washed with a spray of water.

The aluminum plate was further electrochemically grained in a 0.5% aqueous solution of hydrochloric acid containing 0.5% aluminum ion at 50°C in the same manner as the electrolysis in nitric acid. The quantity of electricity when the aluminum plate worked as an anode was 50 C/dm². After the electrochemical graining, the aluminum plate was washed with a spray of water. The resulting aluminum plate was anodized in 15% sulfuric acid containing 0.5% aluminum ion at a current density of 15 A/dm² to form a direct current anodized film of 2.5 g/m², followed by washing with water, followed by drying.

The resulting aluminum support was found to have a center average surface roughness (Ra) of 0.51 µm as measured with a 2 µm diameter probe.

### (3-2) Formation of undercoat layer

An undercoating solution having the following formulation was applied to the resulting aluminum support to form an undercoat layer having a dry thickness of 10 mg/m². Formulation of undercoating solution:

| | |
|---|---|
| Compound of formula: | 0.017 g |
| 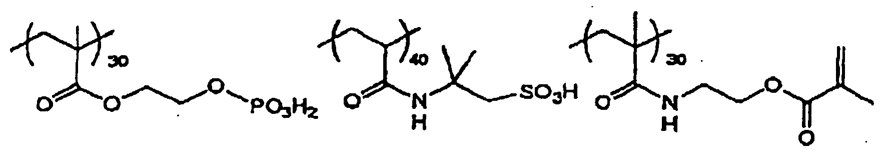 | |
| Methanol | 9.00 g |
| Water | 1.00 g |

### (3-3) Formation of photosensitive layer

A photosensitive coating composition having the following formulation was applied to the undercoat layer side of the aluminum support with a bar coater and baked in an oven at 70°C for 60 seconds to form an image recording layer having a dry thickness of 1.1 g/m².

### Formulation of photosensitive coating composition:

| | |
|---|---|
| Binder polymer 1 shown below (weight average weight: 80,000) | 0.54 g |
| Polymerizable compound (isocyanuric acid/EO-modified Ltd.) triacrylate, ARONIX M-315 from Tpa Gosei Co., | 0.40 g |
| Polymerizable compound (ethoxylated trimethylolpropane triacrylate, SR9035 from Nippon Kayaku Co., Ltd.; number of moles of EO added: 15; molecular weight: 1000) | 0.08 g |
| Sensitizing dye 1 shown below | 0.06 g |
| Polymerization initiator 2 shown below | 0.18 g |
| Chain transfer agent 1 | 0.07 g |
| ε-Phthalocyanine pigment dispersion (pigment: 15 parts (by mass, hereinafter the same); binder polymer 1 (dispersant): 10 parts; solvent: cyclohexanone/methoxypropyl acetate/1-methoxy-2-propanol=15/20/40 by mass) | 0.40 g |
| Thermal polymerization initiator (N-nitrosophenylhydroxylamine aluminum salt) | 0.01 g |
| Water soluble fluoro-containing surfactant 1 | 0.001 g |
| Polyoxyethylene-polyoxypropylene condensate (Pluronic L44 from Asahi Denka) | 0.04 g |
| Tetraethylammonium chloride | 0.01 g |
| 1-Methoxy-2-propanol | 3.5 g |
| Methyl ethyl ketone | 8.0 g |

### Binder polymer 1:

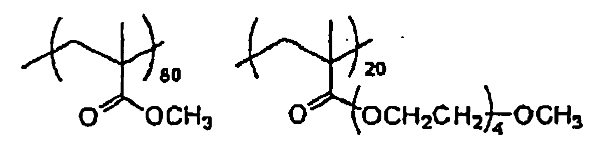

### Sensitizing dye 1:

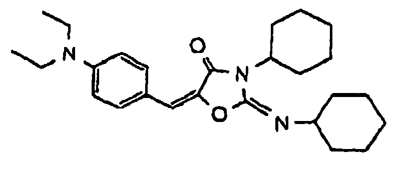

### Polymerization initiator 2:

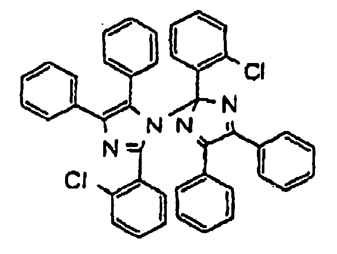

### Chain transfer agent 1:

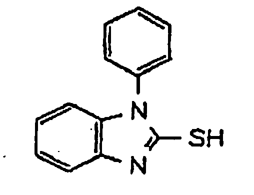

### Fluorine-containing surfactant 1:

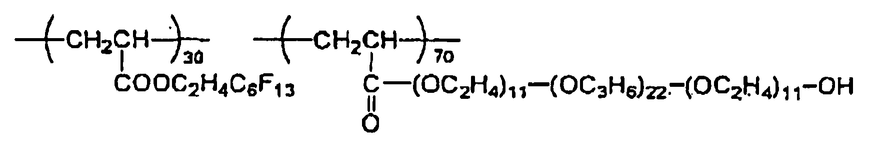

### (3-4) Formation of protective layer

A coating composition of the following formulation was applied to the photosensitive layer with a bar coater to a dry thickness of 0.75 g/m² and dried at 125°C for 70 seconds to form a protective layer. A lithographic printing plate precursor was thus completed.

### Formulation of protective coating composition:

| | |
|---|---|
| Polyvinyl alcohol (degree of saponification: 98 mol%; degree of polymerization: 500) | 40 g |
| Polyvinylpyrrolidone (weight average molecular weight: | |
| 50,000) | 5 g |
| Poly(vinylpyrrolidone/vinyl acetate=1:1) (weight average molecular weight: 70,000) | 0.5 g |
| Surfactant (Emalex 710, from Nihon Emulsion Co., Ltd.) | 0.5 g |
| Water | 950 g |

### (4) Development processing

A total area of 2000 m² of the PS plate thus prepared was developed in the automatic processing apparatus over about one month with no replenishment of the developer. The total amount of the developer consumed was 100 liters.

### COMPARATIVE EXAMPLE

An automatic processing apparatus TOPLINE OE40 from Haase (Germany) having a 92 liter volume development tank filled with a highly alkaline developer (pH 12) having the following formulation was used.

### Developer formulation:

| | |
|---|---|
| Pure water | 950.0 g |
| EDTA salt | 1.5 g |
| Potassium carbonate | 2.2 g |
| KOH (48%) | 1.5 g |
| Polyethylene naphthyl ether (C=14) | 46.0 g |

A total area of 2000 m² of a lithographic printing plate precursor LP-NNV (photopolymerization type CTP plate available from Fuji Film Co., Ltd.) was developed on EO40 over about one month. The developer was replenished to maintain the developing performance. The total amount of the developer consumed was 258 liter.

## Claims

1. An automatic processing method for obtaining a lithographic printing plate, comprising dipping an imagewise exposed lithographic printing plate precursor comprising a support and an image recording layer in a development tank filled with a developer to remove an unnecessary part of the image recording layer, which method further comprises:
- providing an external tank outside a processing line including the development tank;
- circulating the developer through the development tank and the external tank to maintain liquid level of the development tank constant; and
- when the developer in both the development tank and the external tank is 100% exhausted, replacing only the developer of the external tank, followed by continuing development processing.
wherein "100% exhausted" means a state of the developer, wherein the half-tone dot area ratio increases to 52% whilst a half tone dot area ratio of 50% is obtained with a fresh developer.

2. The method of claim 1, wherein, after the developer of the external tank is replaced at least once, the entire developer in both the development tank and the external tank is replaced, and the development processing is continued thereafter.

3. The method of claim 1 or 2, wherein the developer comprises 1-15 wt.-% of a surfactant and has a pH of 2-10.

4. The method of any of claims 1-3, wherein the developer comprises 1-15 wt.-% of a water soluble polymer.

## Patentansprüche

1. Automatisiertes Arbeitsverfahren zum Erhalt einer Lithografiedruckplatte, umfassend das Eintauchen eines bildweise belichteten Lithografiedruckplattenvorläufers, der einen Träger und eine Bildaufzeichnungsschicht umfasst, in einen Entwicklungstank, der mit einem Entwickler gefüllt ist, um einen nicht notwendigen Teil der Bildaufzeichnungsschicht zu entfernen, wobei das Verfahren ferner umfasst:
- Bereitstellen eines externen Tanks außerhalb einer Verarbeitungsline, die den Entwicklungstank umfasst;
- Zirkulieren des Entwicklers durch den Entwicklungstank und den externen Tank, um den Flüssigkeitsstand des Entwicklungstanks konstant zu halten; und
- wenn der Entwickler in sowohl dem Entwicklungstank als auch dem externen Tank zu 100 % erschöpft ist, Ersetzen von nur dem Entwickler des externen Tanks, gefolgt von Fortsetzen der Entwicklungsverarbeitung,
worin "100 % erschöpft" einen Zustand des Entwicklers bezeichnet, worin das Halbtonpunkt-Flächenverhältnis auf 52 % erhöht ist, während ein Halbtonpunkt-Flächenverhältnis von 50 % mit einem frischen Entwickler erhalten wird.

2. Verfahren gemäß Anspruch 1, worin, nachdem der Entwickler des externen Tanks mindestens einmal ersetzt worden ist, der gesamte Entwickler in sowohl dem Entwicklungstank als auch dem externen Tank ersetzt wird und danach die Entwicklungsverarbeitung fortgeführt wird.

3. Verfahren gemäß Anspruch 1 oder 2, worin der Entwickler 1 bis 15 Gew.% eines Tensids umfasst und einen pH-Wert von 2 bis 10 aufweist.

4. Verfahren gemäß irgendeinem der Ansprüche 1 bis 3, worin der Entwickler 1 bis 15 Gew.% eines wasserlöslichen Polymers umfasst.

## Revendications

1. Procédé de traitement automatique pour obtenir une plaque d'impression lithographique, comprenant l'immersion d'un précurseur de plaque d'impression lithographique exposé suivant une image comprenant un support et une couche d'enregistrement d'image dans un réservoir de développement rempli d'un développeur pour enlever une partie inutile de la couche d'enregistrement d'image, lequel procédé comprend en outre :
- la fourniture d'un réservoir externe à l'extérieur d'une ligne de traitement incluant le réservoir de développement ;
- la circulation du développeur à travers le réservoir de développement et le réservoir externe pour maintenir constant le niveau de liquide du réservoir de développement ; et
- lorsque le développeur tant dans le réservoir de développement que le réservoir externe est épuisé à 100 %, le remplacement du seul développeur du réservoir externe, suivi par un traitement de développement ininterrompu.
dans lequel « épuisé à 100 % » signifie un état du développeur, dans lequel le rapport de zone de point en demi-teinte augmente à 52 % pendant qu'un rapport de zone de point en demi-teinte de 50 % est obtenu avec un développeur frais.

2. Procédé selon la revendication 1, dans lequel, après que le développeur du réservoir externe est remplacé au moins une fois, la totalité du développeur tant dans le réservoir de développement que dans le réservoir externe est remplacée, et le traitement de développement est continué après cela.

3. Procédé selon la revendication 1 ou 2, dans lequel le développeur comprend 1 à 15 % en poids d'un agent de surface et a un pH de 2 à 10.

4. Procédé selon l'une quelconque des revendications 1 à 3, dans lequel le développeur comprend de 1 à 15 % en poids d'un polymère soluble dans l'eau.
